# EUROPÄISCHE PATENTSCHRIFT

(11) **EP 1 168 271 B1**
(45) Veröffentlichungstag und Bekanntmachung des Hinweises auf die Patenterteilung: **12.01.2011**
(21) Anmeldenummer: 01113495.4
(22) Anmeldetag: 02.06.2001
(51) Int. Cl.: G08C 19/00, G05B 19/042

(54) **Feldbus-Anschlusssystem für Aktoren oder Sensoren**
Field bus coupling system for actuators or sensors
Système de couplage d'un bus de terrain pour actionneurs ou capteurs

(30) Priorität: 23.06.2000 DE 10030845
(43) Veröffentlichungstag der Anmeldung: 02.01.2002
(73) Patentinhaber: ABB AG, 68309 Mannheim (DE)
(72) Erfinder: Schollenberger, Lothar, 69493 Hirschberg (DE)

(56) Entgegenhaltungen:
- WO-A-97/49017
- WO-A1-00/13319
- DE-A1- 19 847 701
- BOETTCHER J ET AL: "MASCHINEN UND GERAETE EINFACH IN ETHERNET UND PROFIBUS-DP ANKOPPELN" ELEKTROTECHNISCHE ZEITSCHRIFT - ETZ, VDE VERLAG GMBH, BERLIN, DE, Bd. 121, Nr. 13/14, Juli 2000 (2000-07), Seiten 14-17, XP001103575 ISSN: 0948-7387

## Beschreibung

Die Erfindung bezieht sich auf ein Anschlußsystem für den Anschluß von Sensoren oder Aktoren an einen Feldbus.

Feldbusse werden in Automatisierungssystemen zur Verbindung von Sensoren oder Aktoren mit Ein/Ausgabe-Geräten von Steuer- und Regeleinrichtungen eingesetzt. Es ist eine Vielzahl unterschiedlicher Feldbusse marktgängig, und damit eine entsprechende Vielzahl von feldbusspezifischen Feldbusanschaltungen, an die Aktoren oder Sensoren anschließbar sind.

Sensoren werden in Automatisierungssystemen zur Erfassung von Prozeßgrößen eingesetzt, wobei eine große Palette von Sensorarten verwendet wird, die im einfachsten Fall nur ein binäres Signal liefern, aber auch mehrere digitale oder analoge Signale liefern können.

Ähnlich ist die Vielfalt bei Aktoren, die einfache Schaltgeräte sein können, aber auch beispielsweise Frequenzumrichter mit Regelfunktionen.

Ein Anwender von Sensoren oder Aktoren wünscht sich, daß solche Produkte entweder universell verwendbar, also an einen beliebigen Feldbus anschließbar sind, oder wenigstens in unterschiedlicher Ausführung für den Anschluß an unterschiedliche Feldbusse zur Verfügung gestellt werden. Für eine universelle Einsatzmöglichkeit wäre eine Anordnung mehrerer Feldbusanschaltungen in Sensoren oder Aktoren erforderlich, die sich aus Kosten- und Platzgründen verbietet. Die Bereitstellung bezüglich ihres Feldbusanschlusses unterschiedlicher Sensoren oder Aktoren bedeutet für den Lieferanten einen erheblichen Aufwand

Aus der WO-A-97/49017 ist ein Anschlusssystem bekannt, mit dem unterschiedliche externe Geräte an beliebige Busse einer Datenverarbeitungsanlage anschließbar sind.

Der Erfindung liegt daher die Aufgabe zugrunde, ein Anschlußsystem für Sensoren oder Aktoren unterschiedlicher Komplexität an unterschiedliche Feldbussysteme anzugeben, das mit relativ geringem Zusatzaufwand realisierbar ist.

Diese Aufgabe wird durch ein Anschlußsystem mit den im Anspruch 1 angegebenen Merkmalen gelöst. Vorteilhafte Ausgestaltungen sind in weiteren Ansprüchen angegeben.

Bei dem vorgeschlagenen Anschlußsystem für den Anschluß von Sensoren oder Aktoren an eine Feldbusanschaltung eines jeweiligen Feldbussystems ist der Feldbusanschaltung eine Schnittstelleneinrichtung vorgeschaltet, an die wahlweise einfache oder komplexe Sensoren oder Aktoren anschließbar sind. Die Schnittstelleneinrichtung ist dafür eingerichtet, selbsttätig zu prüfen, welche Art eines Sensors oder Aktors angeschlossen ist, und sich auf eine daran angepaßte Betriebsart einzustellen. Diese Prüfung erfolgt mittels eines Testtelegramms, das die Schnittstelleneinrichtung an den angeschlossenen Aktor oder Sensor schickt.

Die Schnittstelleneinrichtung ermöglicht es als Bindeglied, sowohl einfache, als auch komplexe standardisierte Sensoren oder Aktoren an unterschiedliche, ebenfalls standardisierte Busanschaltungen anzuschließen.

Eine weitere Beschreibung der Erfindung und deren Vorteile erfolgt nachstehend anhand eines in der Zeichnung dargestellten Ausführungsbeispiels.

Es zeigt:
Fig. 1 eine schematisierte Darstellung der vorgeschlagenen Anordnung, und
Fig. 2 ein Anordnungsbeispiel.

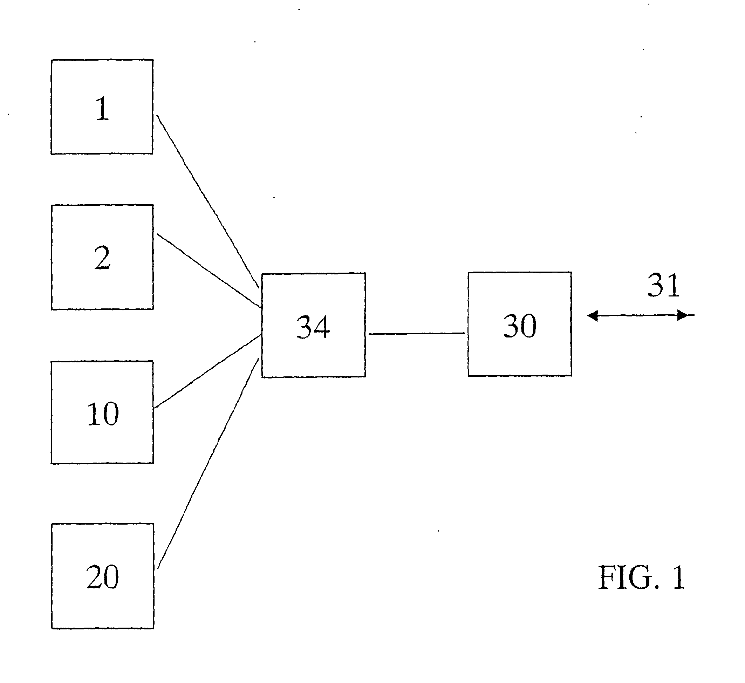

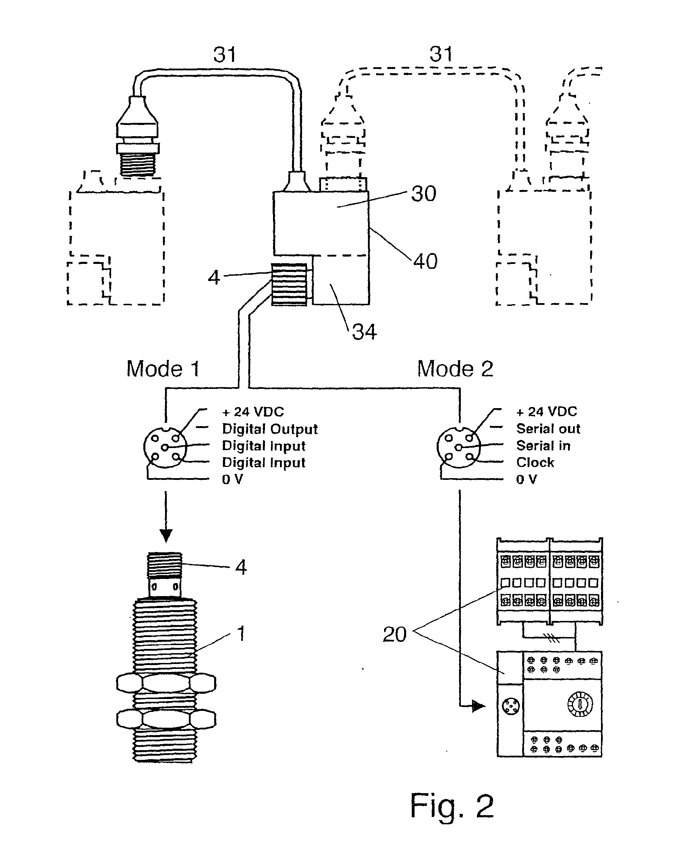

Fig. 1 zeigt in einer Prinzipdarstellung eine Schnittstelleneinrichtung 34, in der eine definierte neutrale, d.h. vom jeweiligen Feldbussystem unabhängige Schnittstelle unter Einsatz einer elektronischen Schaltung, z. B. eines Mikroprozessors oder Mikrocontrollers implementiert ist. Die Schnittstelleneinrichtung 34 ist einer feldbusspezifischen Feldbusanschaltung 30 vorgeschaltet, an die Leitungen eines Feldbusses 31 anschschließbar sind. An die Schnittstelleneinrichtung 34 sind wahlweise sowohl einfache Sensoren 1 oder Aktoren 2, als auch komplexe Sensoren 10 oder Aktoren 20 anschließbar. Die Arbeitsweise einer solchen Anordnung wird nachstehend anhand der Fig. 2 erläutert.

Fig. 2 zeigt ein Anordnungsbeispiel, bei dem eine Feldbus-Steckvorrichtung 40 eingesetzt ist, die elektronische Einrichtungen enthält zur Realisierung einer Feldbusanschaltung 30, an die zwei Feldbuskabel eines Feldbusses 31 anschließbar sind, sowie zur Realisierung einer feldbusunabhängigen Schnittstelleneinrichtung 34. Die Feldbus-Steckvorrichtung 40 weist außerdem eine fünfpolige Standard-Steckvorrichtung 4 auf, an die wahlweise ein Sensor 1 oder 10, oder ein Aktor 2 oder 20 anschließbar ist.

Die Schnittstelleneinrichtung 34 ist dafür eingerichtet, wahlweise in zwei Betriebsarten zu arbeiten; nämlich in einer als Mode 1 bezeichneten ersten Betriebsart, bei der im Parallelbetrieb zwei digitale Signale einlesbar und ein digitales Signal ausgebbar sind, und in einer als Mode 2 bezeichneten zweiten Betriebsart, bei der im seriellen Betrieb Signale ein- und ausgebbar sind. Die Schnittstelleneinrichtung 34 ist außerdem dafür eingerichtet, sich selbsttätig auf die geeignete Betriebsart einzustellen, nachdem ein Aktor oder ein Sensor angeschlossen ist. Sie sendet dazu nach dem Einschalten zunächst ein serielles Testtelegramm in der Betriebsart Mode 2 an das angeschlossene Gerät 1, 2, 10 oder 20 und erwartet ein Antworttelegramm. Wenn diese Antwort nicht eintrifft, wechselt die Schnittstelleneinrichtung 34 zur ersten Betriebsart Mode 1. Die Darstellung in Fig. 2 zeigt, daß beispielsweise ein einfacher Sensor 1 eine Einstellung der ersten Betriebsart Mode 1 bewirkt, ein komplexer Aktor 20 die Einstellung der zweiten Betriebsart Mode 2 mit der jeweils entsprechenden Signalbelegung der Steckanschlüsse, die in Normen festgelegt ist. Grundsätzlich ist es möglich, die Schnittstelleneinrichtung dafür einzurichten, abhängig von der Antwort auf das gesendete Testtelegramm zwischen mehr als zwei Betriebsarten zu unterscheiden.

Es ist ein wesentlicher Vorteil, daß der an der Feldbussteckvorrichtung 40 vorhandene Standard-Steckanschluß 4 in Verbindung mit der automatisierten Einstellung der Betriebsart auf Mode 1 den unmittelbaren Anschluß beispielsweise von induktiven Näherungschaltern in Steckerausführung als Sensoren ermöglicht, deren Anschlußfolge und Steckerbelegung genormt ist. Einfache Schaltgeräte oder Schaltgerätekombinationen benutzen ebenfalls die erste Betriebsart Mode 1. Die zweite Betriebsart Mode 2 wird für Aktoren und Sensoren mit größerem Signalumfang benutzt, wobei neben einfachen binären Signalen auch digitalisierte Analogwerte oder Parameter übertragen werden können.

## Patentansprüche

1. Anschluss-System für den Anschluss sowohl einfacher Sensoren (1) oder Aktoren (2) mit paralleler Signalübertragung, als auch komplexer Sensoren (10) oder Aktoren (20) mit serieller Signalübertragung an eine feldbusspezifische Feldbusanschaltung (30) eines jeweiligen Feldbussystems (31), wobei der Feldbusanschaltung (30) eine feldbusunabhängige Schnittstelleneinrichtung (34) vorgeschaltet ist, an die wahlweise einfache oder komplexe Sensoren (1, 10) oder Aktoren (2, 20) anschließbar sind, welche selbsttätig prüft, welche Art eines Sensors (1, 10) oder Autors (2, 20) angeschlossen ist, und sich auf eine daran angepasste Betriebsart einstellt,
**dadurch gekennzeichnet, dass**
die Schnittstelleneinrichtung (34) mittels einer elektronischen Schaltung dafür eingerichtet ist, sich auf eine von zwei implementierten Betriebsarten einzustellen und nach dem Einschalten der Betriebsspannung zuerst in einer zweiten Betriebsart für seriellen Signaleingang zu arbeiten und ein serielles Testtelegramm an den jeweils angeschlossenen Sensor (1, 10) oder Aktor (2, 20) zu senden und wenn die damit angeforderte Antwort ausbleibt, auf eine erste Betriebsart für parallelen Signaleingang umzuschalten.

2. Anschluss-System nach Anspruch 1, **dadurch gekennzeichnet, dass** die Schnittstelleneinrichtung (34) mittels einem Mikrocontroller dafür eingerichtet ist, sich auf eine von zwei implementierten Betriebsarten einzustellen.

3. Anschluss-System nach einem der vorstehenden Ansprüche, **dadurch gekennzeichnet, dass** die Schnittstelleneinrichtung (34) in eine Feldbus-Steckvorrichtung (40) integriert ist.

4. Anschlußsystem nach einem der vorstehenden Ansprüche, **dadurch gekennzeichnet, dass** die Schnittstelleneinrichtung (34) dafür eingerichtet ist, in allen Betriebsarten ein serielles Ausgangssignal auszugeben.

5. Anschluss-System nach einem der vorstehenden Ansprüche, **dadurch gekennzeichnet, dass** an die Schnittstelleneinrichtung (34) einfache Sensoren(1) oder Aktoren (2) mittels einer Standard-Steckvorrichtung (4) mit genormter Steckerbelegung unmittelbar anschließbar sind.

## Claims

1. Connecting system for connection not only of simple sensors (1) or actuators (2) with parallel signal transmission but also of complex sensors (10) or actuators (20) with serial signal transmission to a fieldbus-specific fieldbus interface circuit (30) of a respective fieldbus system (31), with the fieldbus interface circuit (30) having an upstream fieldbus-independent interface device (34) to which simple or complex sensors (1, 10) or actuators (2, 20) can optionally be connected, and which autonomously checks what type of sensor (1, 10) or actuator (2, 20) is connected and selects an appropriate operating mode for it, **characterized in that** the interface device (34) is set up by means of an electronic circuit to select one of two implemented operating modes, and to operate firstly in a second operating mode for serial signal input once the operating voltage has been switched on, and to send a serial test message to the respectively connected sensor (1, 10) or actuator (2, 20) and, in the absence of the response required to this, to switch to a first operating mode for parallel signal input.

2. Connecting system according to Claim 1, **characterized in that** the interface device (34) is set up by means of a microcontroller to select one of two implemented operating modes.

3. Connecting system according to one of the preceding claims, **characterized in that** the interface device (34) is integrated in a fieldbus plug-in apparatus (40).

4. Connecting system according to one of the preceding claims, **characterized in that** the interface device (34) is set up to output a serial output signal in all operating modes.

5. Connecting system according to one of the preceding claims, **characterized in that** simple sensors (1) or actuators (2) can be connected directly to the interface device (34) by means of a standard plug-in apparatus (4) having a standardized connector wiring.

## Revendications

1. Système de raccordement pour raccorder aussi bien des capteurs (1) ou des actionneurs (2) simples avec transmission en parallèle de signaux que des capteurs (10) ou des actionneurs (20) complexes avec transmission en série de signaux à une connexion de bus de terrain (30) spécifique au bus de terrain d'un système de bus de terrain (31) respectif, la connexion de bus de terrain (30) étant précédée par un dispositif d'interface (34) indépendant du bus de terrain auquel peuvent être raccordés, au choix, des capteurs (1, 10) ou des actionneurs (2, 20) simples ou complexes, qui contrôle automatiquement le type de capteur (1, 10) ou d'actionneur (2, 20) qui est raccordé et qui se règle sur un mode de fonctionnement adapté à ceux-ci **caractérisé en ce que**
le dispositif d'interface (34) est conçu pour, au moyen d'un circuit électronique, se régler sur l'un des deux modes de fonctionnement mis en oeuvre et, après la mise sous tension de service, fonctionner tout d'abord dans un deuxième mode de fonctionnement pour une entrée en série du signal et envoyer un télégramme de test série au capteur (1, 10) ou à l'actionneur (2, 20) respectivement connecté et, lorsque la réponse ainsi sollicitée reste absente, permuter sur un premier mode de fonctionnement pour une entrée en parallèle du signal.

2. Système de raccordement selon la revendication 1, **caractérisé en ce que** le dispositif d'interface (34) est conçu pour, au moyen d'un microcontrôleur, se régler sur l'un des deux modes de fonctionnement mis en oeuvre.

3. Système de raccordement selon l'une des revendications précédentes, **caractérisé en ce que** le dispositif d'interface (34) est intégré dans un dispositif à enficher pour bus de terrain (40).

4. Système de raccordement selon l'une des revendications précédentes, **caractérisé en ce que** le dispositif d'interface (34) est conçu pour délivrer un signal de sortie série dans tous les modes de fonctionnement.

5. Système de raccordement selon l'une des revendications précédentes, **caractérisé en ce que** des capteurs (1) ou des actionneurs (2) simples peuvent être raccordés directement au dispositif d'interface (34) au moyen d'un dispositif à enficher standard (4) ayant un brochage normalisé.
